# EUROPÄISCHE PATENTSCHRIFT

(11) **EP 2 803 961 B1**
(45) Veröffentlichungstag und Bekanntmachung des Hinweises auf die Patenterteilung: **17.01.2024**
(21) Anmeldenummer: 14167351.7
(22) Anmeldetag: 07.05.2014
(51) Int. Cl.: G01J 5/04, G01J 1/04, G01J 1/42, G01J 1/02

(54) **Hermetisch gasdichtes optoelektronisches oder elektrooptisches Bauteil sowie Verfahren zu seiner Herstellung**
Hermetically gas-tight optoelectronic or electro-optical component and method for manufacturing the same
Composant hermétique électro-optique ou opto-électronique étanche au gaz et son procédé de fabrication

(30) Priorität: 14.05.2013 DE 102013104964
(43) Veröffentlichungstag der Anmeldung: 19.11.2014
(73) Patentinhaber: Micro-Hybrid Electronic GmbH, 07629 Hermsdorf (DE)
(72) Erfinder: Biermann, Steffen, 07629 Hermsdorf (DE); Magi, André, 07619 Mertendorf (DE); Sachse, Patrick, 07586 Kraftsdorf (DE)
(74) Vertreter: Gleim Petri Patent- und Rechtsanwaltspartnerschaft mbB

(56) Entgegenhaltungen:
- EP-A2- 1 727 210
- EP-A2- 1 764 609
- EP-B1- 1 727 210
- DE-A1- 4 301 457
- DE-A1-102004 013 850
- DE-A1-102004 031 317
- DE-A1-102004 031 318
- DE-A1-102009 012 394
- DE-B4-102004 013 850
- S. GARCIA-BLANCO ET AL: "Low-temperature vacuum hermetic wafer-level package for uncooled microbolometer FPAs", SPIE PROCEEDINGS, vol. 6884, 7 February 2008 (2008-02-07), page 68840P, XP055574290, US DOI: 10.1117/12.761324 ISBN: 978-1-5106-3673-6
- Lau John H. ET AL: "Advanced MEMS Packaging" In: "Advanced MEMS Packaging", 22 October 2009 (2009-10-22), McGraw Hill, New York, XP055954420, pages 327-352,

## Beschreibung

Die Erfindung betrifft ein hermetisch gasdichtes elektronisches Bauteil, wie dies gattungsgemäß aus der DE 33 35 530 A1 bekannt ist. Die Erfindung betrifft ferner ein Verfahren zur Herstellung eines hermetisch gasdichten optoelektronischen oder elektrooptischen Bauteils.

Um Messungen der Zusammensetzung von Gasen oder Gasgemischen mittels Sensoren, insbesondere mittels Infrarotsensoren (IR-Sensoren), dauerhaft zuverlässig vornehmen zu können, ist eine gasdichte Kapselung der Sensoren gegenüber den zu untersuchenden Gasen oder Gasgemischen erforderlich. Insbesondere dann, wenn Messungen bei Temperaturen über Raumtemperatur erfolgen, können sich die Materialien der Sensoren verändern und Driften der Messwerte der Sensoren auftreten. Verschärft wird dieser Effekt, wenn die Gase oder Gasgemische gegenüber den Materialien der Sensoren aggressiv wirken. Dabei wirken besonders hohe Wasserdampfgehalte sowie das Vorhandensein von Sauerstoff oder Radikalen schädigend auf die Sensoren. Die gleiche Problematik trifft für IR-Strahler zu.

Es ist daher bekannt, elektronische Bauteile hermetisch einzukapseln. Aus der DE 33 35 530 A1 ist ein Substrat (Träger) bekannt, auf dem eine elektronische Schaltung aufgebracht ist. Die Schaltung ist durch eine Abdeckkappe (fortan: Gehäusekappe) aus einem keramischen Material, Kupfer oder Stahl vollständig überdeckt. Die Gehäusekappe weist einen umlaufenden Rand mit einer lötfähigen Unterseite auf. Der Träger kann eine Keramikplatte oder eine großflächig emaillierte Leiterplatte sein. Auf dem Träger ist eine Leiterbahn aufgedruckt, die einem Umriss der Unterseite des Gehäusekappenrandes entspricht. Die Gehäusekappe und der Träger sind entlang dieses Umrisses miteinander verlötet und damit gasdicht verbunden. In einer weiteren Ausgestaltung gemäß der DE 33 35 530 A1 besteht die Gehäusekappe vollständig aus Stahl und der Träger weist eine emaillefreie Metallzone auf, die entlang der Metallzone mit dem Gehäusekappenrand verschweißt wird. Benötigte elektrische Kontakte zur Kontaktierung der gekapselten elektronischen Schaltung sind durch den Träger geführt und gasdicht in Pressglas eingeschmolzen. Die montierte Gehäusekappe kann mit einem Gas gefüllt werden, um gewünschte Eigenschaften wie den Taupunkt oder die Wärmeleitfähigkeit zu beeinflussen.

Ein derart hergestelltes elektronisches Bauteil ist gut gegen Umwelteinflüsse abgeschirmt. Allerdings eignet sich das elektronische Bauteil nicht für eine Hausung eines optoelektronischen oder elektrooptischen Wandlerelements, da kein Strahlengang zwischen dem Wandlerelement und einer Messumgebung vorhanden ist.

Aus dem Stand der Technik (DE 20 2009 006 481 U1) ist zwar die Möglichkeit bekannt, dass eine Gehäusekappe eines elektronischen Bauteils einen Durchbruch aufweisen kann, der durch ein transparentes Fenster abgedeckt ist und somit einen Strahlengang zwischen dem Wandlerelement und einer Messumgebung ermöglicht, allerdings erlaubt die in der DE 20 2009 006 481 U1 offenbarte Ausgestaltung (nicht gasdicht ausgebildeter Spritzwasserschutz) aus den oben genannten Gründen keine Verwendung bei Temperaturen deutlich oberhalb der Raumtemperatur oder in Umgebungen mit aggressiven Medien. Bei einer Kombination eines transparenten Fensters gemäß der DE 20 2009 006 481 U1 in einer Gehäusekappe, wie diese in der DE 33 35 530 A1 beschrieben ist, würde es mindestens an einer hermetisch gasdichten Verbindung zwischen Fenster und Gehäusekappe fehlen.

Ein elektrooptischer Sensor mit metallischer Kappe und eingelötetem nichtmetallischen Fenster ist aus DE102009 012 394 bekannt. Als Randmetallisierung des Fensters wird eine Cr-Schicht verwendet, die mittels Au, Ag oder Sn verlötet wird. S. Garcia-Blanco et al., Low-temperature vacuum hermetic wafer-level package for uncooled microbolometer FPAs, Proc. SPIE 6884, Reliability, Packaging, Testing, and Characterization of MEMS/MOEMS VII, 68840P (18 February 2008) beschreibt eine Verpackung für ein MEMS-Mikrobolometer, bei der ein mit einer Ti/Ni/Au-Metallisierung beschichteter Siliziumwafer mit einem Cr/Ni/Au-beschichteten Keramikelement verlötet wird.

Ferner ist aus John H. Lau et al., Advanced MEMS Packaging, McGraw-Hill, Kapitel 7, S. 342-344 eine MEMS-Mikrobolometerverpackung mit einem Germaniumfenster bekannt, das ein Schichtsystem aus Oxid/Ti/Ni/Au als Randmetallisierung aufweist. Die Haftung von Cr / Ni / Au Metallisierungen wird als unzureichend dargestellt.

Der Erfindung liegt die Aufgabe zugrunde eine Möglichkeit vorzuschlagen, mittels der in Messumgebungen mit Temperaturen über Raumtemperatur und Temperaturschwankungen sowie mit aggresiven Medien und Feuchtigeit dauerhaft zuverlässige optoelektronische Messugen und Analysen von Gasen oder Gasgemischen vorgenommen werden können. Es ist ferner Aufgabe der Erfindung eine Möglichkeit aufzuzeigen, mittels der optoelektronische und elektrooptische Einheiten auch bei hohen und schwankenden Temperaturen schädigenden Umwelteinflüssen, wie z.B. Feuchtigkeit, dauerhaft hermetisch gasdicht gehalten werden können.

Die Aufgabe wird in einem Verfahren zur Herstellung eines hermetisch gasdichten optoelektronischen oder elektrooptischen Bauteils zur optoelektronischen Messung und Analyse von Gasen oder Gasgemischen mit hoher Robustheit gegen Wärme und Feuchtigkeit, mit den Schritten von Anspruch 1 gelöst.

Die Schritte a) bis d) des Verfahrens nach Anspruch 1 können natürlich in beliebiger Reihenfolge durchgeführt werden.

Von Bedeutung ist lediglich, dass die Elemente Träger, Gehäusekappe, Wandlerelement und Fensterelement zu Beginn der Montage mit den beschriebenen Modifikationen vorliegen. Es ist ferner nicht von Bedeutung, ob zuerst das Fensterelement mit der Gehäusekappe verbunden wird und dann die Gehäusekappe auf den Träger aufgesetzt wird oder ob zuerst das Aufsetzen erfolgt und dann das Fensterelement mit der Gehäusekappe verbunden wird. Der Schritt des Verbindens der Gehäusekappe mit dem Träger ist ebenfalls variabel. Er kann vor, nach oder gleichzeitig mit dem Verbinden des Fensterelements mit der Gehäusekappe erfolgen.

Ein optoelektronisches Wandlerelement setzt optische Informationen, z. B. eine detektierte elektromagnetische Strahlung, in ein elektrisches Signal um (Sensor). Unter einem elektrooptischen Wandlerelement werden solche elektronischen Schaltungen und Vorrichtungen verstanden, die aufgrund eines elektrischen Signals ein optisches Signal erzeugen (z. B. IR-Strahler, Leuchtdioden etc.). Nachfolgend wird vereinfachend von einem Wandlerelement gesprochen.

Zum Ausbilden einer verbindenden Naht durch Erschmelzen metallischen Materials werden zusammenfassend die Fügetechniken des Lötens und des Schweißens verstanden. Das Löten kann entweder unter Zuhilfenahme eines Lotmaterials erfolgen (z. B. Schmelzlöten) oder ohne Lotmaterial (z. B. Diffusionslöten) durchgeführt werden. Beim Löten werden die Schmelztemperaturen der Materialien der jeweiligen Fügepartner nicht erreicht. Beim Schweißen dagegen werden die Schmelztemperaturen der Materialien der jeweiligen Fügepartner erreicht. Das Schweißen kann mit (z. B. Schmelzschweißen) oder ohne (z. B. Diffusionsschweißen, Widerstandsschweißen, Impulsschweißen, Reibschweißen) Schweißzusatzwerkstoff erfolgen.

Eine Naht ist entlang einer Fügelinie, an der die Fügepartner (Gehäusekappe und Träger bzw. Fensterelement) miteinander zu verbinden sind, genau dann ausgebildet, wenn nach kurzzeitigem (transient) Erschmelzen metallischen Materials durch Erstarren desselben eine durchgehende Verbindung der Fügepartner geschaffen wurde. Je nach Wahl des Fügeverfahrens kann das erschmolzene metallische Material ein Lotmaterial, ein Schweißzusatzwerkstoff oder die Materialien der Fügepartner selbst sein.

Der technische Begriff "hermetisch gasdicht" wird im Sinne dieser Beschreibung für Verbindungen verwendet, deren Leckdichtigkeit (Leckrate) kleiner als 10⁻⁸ mbar I/s, vorzugsweise sogar kleiner bis zu 10⁻¹⁰ mbar I/s ist. Wenn von einer hermetisch gasdichten Verbindung von Gehäusekappe und Fensterelement bzw. Träger gesprochen wird, ist es selbstverständlich, dass eine Naht eines erschmolzenen metallischen Materials mindestens so lang ausgebildet ist, dass die genannten Elemente über die gesamte Länge ihres Kontakts zueinander im Sinne der oben gegebenen Definition hermetisch gasdicht miteinander verbunden sind.

Das Fensterelement ist in einer bevorzugten Ausführung des erfindungsgemäßen Verfahrens als eine Platte aus einem transparenten Material hergestellt. Das transparente Material wird dabei vorzugsweise aus der Gruppe der Materialien: Saphir (Al₂O₃), Magnesiumfluorid (MgF₂), Magnesiumoxid (MgO), Lithiumfluorid (LiF), Calciumfluorid (CaF₂), Bariumfluorid (BaF₂), Silizium (Si), Siliziumdioxid (SiO₂) Germanium (Ge), Zinkselenid (ZnSe), Zinksulfid (ZnS), Cadmiumtellurid (CdTe), Galliumarsenid (GaAs), Titandioxid (TiO₂), Y-teilstabilisiertes Zirkoniumdioxid (ZrO₂), einer Mischung aus Thalliumbromid und Thalliumjodid (KRS 5; TI(Br-J)) Flintglas oder Quarzglas ausgewählt.

Die Randmetallisierung dient dazu, ein ausgewähltes Verfahren zur Herstellung der Naht unter Erschmelzung metallischen Materials zu ermöglichen. Durch die Randmetallisierung wird ein Stoffschluss zwischen den Materialien der Fügepartner vermittelt. Ist das Material eines Fügepartners, beispielsweise das Material des Fensterelements, selbst z. B. nicht löt- oder schweißfähig, so wird durch die Randmetallisierung eine Verbindung durch eine Naht unter Verwendung erschmolzenen metallischen Materials überhaupt erst ermöglicht.

In nicht unter die Ansprüche fallenden Ausführungen kann die Randmetallisierung eine einzelne Schicht eines metallischen Materials sein. In anspruchsgemässen Ausführungen der Erfindung ist sie eine Schichtenfolge von mindestens zwei Schichten.

Eine solche Schichtenfolge beinhaltet beginnend am Fensterelement mindestens eine Schicht eines der Metalle Chrom oder Titan. Durch Kombinationen mindestens zweier Metalle als Schichten der Schichtenfolge ist es ermöglicht, eine vorteilhafte Haftvermittlung zwischen den Fügepartnern zu schaffen. Die Materialien, Dicken, Abfolge und Anzahl der Schichten der Schichtenfolge können entsprechend den Materialien der Fügepartner und des verwendeten Fügeverfahrens gewählt werden. Unter die Ansprüche fallende Schichtenfolgen sind beispielsweise durch Kombinationen von Chrom und Nickel, bzw. von Titan und Platin oder Palladium gegeben.

Vorteilhafte Schichtenfolgen sind in den Ansprüchen 1 und 3 angegeben.

In den wesentlichen Ausführungsformen des erfindungsgemäßen Verfahrens werden als Haftvermittler zum Substrat Titan oder Chrom verwendet. Als metallische Materialien zur Herstellung für die Lötverbindung können Platin, Palladium oder Eisen-Nickel verwendet werden. Zur Erzeugung einer Schutzschicht / eine Benetzungsschicht können außerdem bevorzugt Gold bzw. Nickel eingesetzt werden.

Hergestellt wird die Randmetallisierung vorzugsweise mittels eines Gasphasenabscheidungsverfahrens wie z. B. CVD (chemical vapor deposition, chemische Gasphasenabscheidung) oder PVD (physical vapor deposition, physikalische Gasphasenabscheidung) oder mittels eines elektrochemischen Verfahrens, z. B. eines galvanischen Verfahrens.

Wird für den Träger und/oder die Gehäusekappe ein Material gewählt, das nicht lötfähig bzw. nicht schweißfähig ist, können geeignete Randmetallisierungen auch auf dem Träger, auf der Gehäusekappe oder an beiden aufgebracht werden.

Um das Vorhandensein von reaktionsfreudigen chemischen Elementen oder Verbindungen und/oder von Radikalen im Innenraum des elektronischen Bauteils zu reduzieren kann vor der Herstellung der hermetisch gasdichten Verbindung zwischen der Gehäusekappe und dem Träger der Innenraum mit einem Gas oder mit einem Gasgemisch gefüllt werden. Der Innenraum kann stattdessen auch evakuiert werden. Es ist zudem möglich, dass der Innenraum zuerst mit einem Spülgas gefüllt und dann evakuiert wird. Mit letztgenannter Vorgehensweise kann ein möglicher Restanteil von reaktionsfreudigen Elementen bzw. Verbindungen sowie von Radikalen weiter verringert werden.

Als Material der Gehäusekappe sind beispielsweise Metalle wie Stahl oder Nickel, Metalllegierungen sowie Verbundwerkstoffe gewählt, wobei das Material es erlauben muss, eine Leckrate von kleiner 10⁻⁸ mbar I/s einzuhalten. Es kann als Material auch Kovar gewählt sein. Unter Kovar werden Legierungen verstanden, deren Ausdehnungskoeffizienten gering sind und gut an Ausdehnungskoeffizienten angepasst werden können. Dies ist z. B. günstig für eine Spannungsreduzierung an der Verbindung Gehäusekappe - Fensterelement.

Der Träger kann beispielsweise aus Keramik, Metalle wie Stahl oder Nickel, Metalllegierungen sowie Verbundwerkstoffe oder Kovar bestehen.

Das gemäß dem erfindungsgemäßen Verfahren hergestellte elektronische Bauteil erweist sich als sehr robust gegenüber Umgebungsbedingungen wie Wärme und Feuchtigkeit. So werden durch erfindungsgemäße elektronische Bauteile zulässige Messtoleranzen auch noch nach mindestens 10000 Stunden bei einer Temperaturbelastung von 250°C eingehalten. Weitere Tests erwiesen die Robustheit der elektronischen Bauteile selbst nach 18000 Stunden bei 185°C. Bei einer Dauerbelastung von mindestens 3000 Stunden bei -55°C weisen die elektronischen Bauteile ebenfalls zulässige Messtoleranzen auf. Die elektronischen Bauteile sind außerdem robust gegenüber Temperaturwechselbelastung von +20 bis +200°C und -40 bis +85°C. Dabei werden schnelle Temperaturwechsel mit Übergangszeiten kleiner 10 Sekunden als auch langsame Temperaturwechsel mit Änderungsraten von 5 K/min über eine Zyklenzahl von mindestens 1000 überstanden. Die elektronischen Bauteile sind außerdem robust bei einem Druck von 400 kPa. Ferner sind die elektronischen Bauteile robust bei Temperatur-/Luftfeuchtebelastungen von 85°C / 85%rH (= 491 hPa) für 8500 Stunden bzw. bei 95°C / 95%rH (= 803 hPa) für 5200 Stunden.

Die Aufgabe wird ferner durch ein elektronisches Bauteil gemäß Anspruch 6 gelöst

In einer ersten Ausführung des erfindungsgemäßen elektronischen Bauteils ist das mindestens eine Wandlerelement ein optoelektronischer Empfänger, sodass das elektronische Bauteil ein robuster Sensor zur optoelektronischen Messung und Anlyse von Gasen oder Gasgemischen ist.

Mindestens einem der Durchbrüche ist im jeweiligen Strahlengang mindestens ein optisches Filter zugeordnet. Dieses optische Filter (auch kurz: Filter) ist verschieden vom Fensterelement, welches zwar für diejenige Strahlung, die für das Wandlerelement relevant ist transparent ist, aber zwangsläufig eine unvermeidbare optische Wirkung entfaltet (Brechung, Absorption, Transmissivität). Das Filter kann so dimensioniert sein, dass es in mehreren Strahlengängen optisch wirksam wird. Es können mehrere Filter in einem Strahlengang angeordnet sein. Die Filter können individuell relativ zum Strahlengang verkippt sein oder ansteuerbar und gesteuert verkippbar sein. Durch ein gesteuertes Verkippen eines oder mehrerer optischer Filter sind Korrekturen der Wellenlängen der detektierten bzw. der abgestrahlten Strahlung möglich. Da ein optisches Filter üblicherweise aus mehreren optischen Schichten besteht, kann über ein Verkippen die Weglänge des jeweiligen Strahlengangs innerhalb des optischen Filters sowie die Auftreffwinkel von Strahlen der Strahlung auf dem optischen Filter eingestellt werden. Durch Wirkung von Weglängen und Grenzflächeneffekten wie Interferenzen können Eigenschaften der Strahlung (z. B. Wellenlänge) gezielt beeinflusst werden.

Zusätzlich zu einem oder mehreren, oder anstatt eines oder mehrerer, optischer Filter können auch optisch wirksame Elemente wie z. B. Blenden in dem Strahlengang angeordnet sein. Durch Blenden, die beispielsweise zusätzlich zu mindestens einem Filter in dem Strahlengang vorhanden sind, kann auftretende unerwünschte Streustrahlung weitgehend abgeschirmt werden.

Ein Strahlengang ist senkrecht, wenn er entlang einer optischen Achse zwischen Wandlerelement und Durchbruch verläuft und die optische Achse orthogonal auf einer Strahlung empfangenden oder abstrahlenden Oberfläche des Wandlerelements steht. Ein Strahlengang gilt auch als "im Wesentlichen senkrecht", wenn die optische Achse gegenüber der Flächennormalen der empfangenden oder abstrahlenden Oberfläche des Wandlerelements bis zu 15° geneigt ist.

Eine Strahlung ist für das Wandlerelement relevant, wenn diese Strahlung von dem Wandlerelement detektierbar ist oder abgestrahlt wird.

Mehrere Strahlengänge liegen vor, wenn mindestens zwei Durchbrüche vorhanden sind. In einem erfindungsgemäßen elektronischen Bauteil sind die mindestens zwei Durchbrüche hermetisch gasdicht mit mindestens einem Fensterelement verschlossen. Die Strahlengänge können als separate Strahlengänge zu je einem optoelektronischen Empfänger vorhanden sein. Durch ein Fensterelement kann entweder jeweils ein Durchbruch oder mindestens zwei Durchbrüche hermetisch gasdicht verschlossen sein.

In einer weitergehenden Ausführung des erfindungsgemäßen elektronischen Bauteils sind die separaten Strahlengänge zu je einem Empfänger mindestens ein Messstrahlengang und mindestens als ein Referenzstrahlengang ausgebildet. Es ist dabei günstig, wenn der Messstrahlengang und der Referenzstrahlengang möglichst nah beieinander liegen, um eine gute Vergleichbarkeit der Messstrahlen und der Referenzstrahlen zu gewährleisten.

Es ist möglich, dass zwischen dem optischen Filter und dem Fensterelement ein Zwischenraum vorhanden ist. Dadurch wird einerseits ein direkter Kontakt von optischem Filter und Fensterelement vermieden und andererseits wird das optische Filter beim Verbinden von Fensterelement und Gehäusekappe geringeren thermischen Belastungen ausgesetzt, wenn das optische Filter vorher in dem Strahlengang innerhalb des Innenraums des Gehäuses angeordnet wurde.

Außerdem wird durch einen Zwischenraum vorteilhaft vermieden, dass sich ungewollt entstehendes Gas unmittelbar zwischen optischem Filter und Fensterelement sammelt und zu Druckbelastungen auf das optische Filter führt. Solche unerwünschten Gase können beispielsweise durch Luft- und/oder Materialeinschlüsse während der Montage entstehen. Werden diese Luft- und/oder Materialeinschlüsse während des Betriebs des elektronischen Bauteils erwärmt, kann es zum Ausgasen bzw. zur Ausdehnung der unerwünschten Gase kommen.

Es ist daher ferner sehr günstig, wenn der Innenraum des Gehäuses und der Zwischenraum zwischen dem optischen Filter und dem Fensterelement durch mindestens einen Kanal zum Gasaustausch und Druckausgleich verbunden ist.

In einer weiteren Ausgestaltung des erfindungsgemäßen elektronischen Bauteils, ist das Wandlerelement eine elektrooptische Strahlungsquelle zur Abstrahlung eines gerichteten Bündels der Strahlung für die optoelektronische Messung und Analyse von Gasen oder Gasgemischen durch optoelektrischen Emphänger. Der Reflektor ist, vorzugsweise rotationssymmetrisch, entlang eines anfänglichen Abschnitts des Strahlengangs angeordnet, sodass das elektronische Bauteil als eine Strahlereinheit zur Abstrahlung eines gerichteten Strahlenbündels ausgebildet ist. Der Reflektor kann als ein Teil der Gehäusewand ausgeführt sein. Beispielsweise kann eine Innenseite des Gehäuses entsprechend als ein Reflektor geformt und gegebenenfalls beschichtet sein. Eine Oberflächenbehandlung wie Polieren oder Strukturieren steht einem Beschichten gleich.

Eine andere Möglichkeit der Bereitstellung einer Strahlereinheit besteht darin, dass das Wandlerelement eine elektrooptische Strahlungsquelle Strahlung für die optoelektronische Messung und Analyse vun Gasen oder Gasgemischen durch einen optoelektronische Emphänger ist und auf der Gehäusekappe über dem Durchbruch ein Reflektor vorhanden ist, sodass das elektronische Bauteil mit dem Reflektor als eine Strahlereinheit zur Abstrahlung eines gerichteten Strahlenbündels ausgebildet ist. In einer solchen Ausführung ist der Reflektor außerhalb des Gehäuses angeordnet. In einem einfachen Fall ist der Reflektor auf das Gehäuse aufgesteckt. Es ist bevorzugt, dass der Reflektor zusätzlich an seiner Position gesichert, beispielsweise stoffschlüssig (aufgeklebt, angelötet, angeschweißt) oder kraft-formschlüssig gehalten ist. Eine solche Ausgestaltung erlaubt eine Konfektionierung eines elektronischen Bauteils mit einem situationsabhängig ausgewählten Reflektor.

Das erfindungsgemäße elektronische Bauteil in seinen verschiedenen Ausgestaltungen und Herstellungsvarianten kann in einer Messzelle verwendet sein. Das elektronische Bauteil ist insbesondere zur Verwendung in IR-Messzellen zur Messung und Analyse von Gasen und Gasgemischen einsetzbar.

Eine solche Messzelle weist mindestens ein elektronisches Bauteil auf, das als ein Sensor ausgebildet ist und mindestens ein elektronisches Bauteil, das als Strahlereinheit ausgebildet ist. Beide elektronischen Bauteile sind einander gegenüberliegend entlang einer gemeinsamen Achse positioniert. Sie werden mittels eines Messzellengehäuses in einem definierten Abstand gehaltert. Durch den definierten Abstand ist eine Messstrecke gebildet, entlang der Messungen von Eigenschaften eines in der Messzelle befindlichen oder durch die Messzelle durchgeleiteten Gases oder Gasgemischs erfolgen.

In einer weiteren Ausgestaltung einer erfindungsgemäßen Messzelle ist ebenfalls mindestens ein elektronisches Bauteil vorhanden, das als ein Sensor ausgebildet ist und mindestens ein elektronisches Bauteil, das als Strahlereinheit ausgebildet ist. Beide elektronischen Bauteile sind nebeneinander angeordnet und entlang einer gemeinsamen, mindestens einmal umgelenkten, optischen Achse positioniert. Zum Umlenken der optischen Achse ist mindestens eine Spiegeleinheit vorhanden, die gegenüber den beiden elektronischen Bauteilen mittels eines Messzellengehäuses gehaltert ist. Die mindestens eine Spiegeleinheit gilt als gegenüber der elektronischen Bauteile angeordnet und gehaltert, wenn die optische Achse als gemeinsame optische Achse der elektronischen Bauteile ausgebildet ist und durch Wirkung der Spiegeleinheit umgelenkt wird. Es können weitere Spiegeleinheiten vorhanden sein, die ebenfalls gegenüber den elektronischen Bauteilen gehaltert sind.

Zusätzlich ist es möglich, dass mindestens eine Spiegeleinheit zwischen oder neben den elektronischen Bauteilen angeordnet ist. Durch eine solche Ausgestaltung kann die optische Achse mehrfach gefaltet sein und somit eine entsprechend lange Messstrecke zwischen dem Strahler und dem Sensor in der Messzelle realisiert werden, ohne dass das Messzellengehäuse mehrere Dezimeter lang wird. Alle oder einzelne Spiegeleinheiten können ansteuerbar und verstellbar sein. Spiegeleinheiten können beispielsweise einen oder mehrere einfache metallische Spiegel, dichroitische Spiegel, Interferenzspiegel, (Mikro-)Spiegelarrays und / oder abbildende Spiegel, z. B. elliptische (konkave), enthalten, wobei bei Anordnung des Letzterem Strahlereinheit und Sensor in den beiden Brennpunkten der Ellipse angeordnet sind .

Das Messzellengehäuse ist vorzugsweise als ein rohrförmiges Gebilde mit Öffnungen zum Gasdurchtritt ausgebildet. Ein rohrförmiges Gebilde kann einen runden, ovalen, unregelmäßigen oder eckigen Querschnitt aufweisen. Der Querschnitt kann sich in Form und Dimension über eine Länge des Messzellengehäuses verändern. Als Material des Messzellengehäuses kann ein Metall wie Stahl oder Aluminium verwendet sein. Aluminium ist ein günstiges Material, da es gut eloxierbar ist.

Die Voraussetzung zur erfindungsgemäßen Lösung der Aufgabe ist eine Gehäusekappe eines Gehäuses eines elektronischen Bauteils, die eine Öffnung an der Fußfläche der Gehäusekappe aufweist und dadurch gekennzeichnet ist, dass weiterhin mindestens ein Durchbruch in der Gehäusekappe vorhanden ist, der durch ein Fensterelement vorgegebener Transparenz hermetisch gasdicht verschlossen ist, wobei das Fensterelement entlang einer Randmetallisierung des Fensterelements mit der Gehäusekappe um den mindestens einen Durchbruch durch eine umlaufende Naht aus kurzzeitig (transient) erschmolzenem Metall hermetisch gasdicht verbunden ist.

Die Erfindung wird nachfolgend anhand von Abbildungen und Ausführungsbeispielen näher erläutert. Dabei zeigen:
- Fig. 1: eine erste Ausführung eines erfindungsgemäßen elektronischen Bauteils mit einem Wandlerelement im Längsschnitt,
- Fig. 2: eine schematische Darstellung einer erfindungsgemäßen Gehäusekappe,
- Fig. 3: eine schematische Darstellung eines erfindungsgemäßen Fensterelements,
- Fig. 4: eine zweite Ausführung eines erfindungsgemäßen elektronischen Bauteils mit zwei Wandlerelementen im Längsschnitt,
- Fig. 5: eine dritte Ausführung eines erfindungsgemäßen elektronischen Bauteils mit zwei Wandlerelementen im Längsschnitt,
- Fig. 6: eine vierte Ausführung eines erfindungsgemäßen elektronischen Bauteils mit einer ersten Ausführung eines inneren Reflektors im Längsschnitt,
- Fig. 7: eine fünfte Ausführung eines erfindungsgemäßen elektronischen Bauteils mit einer zweiten Ausführung eines inneren Reflektors im Längsschnitt,
- Fig. 8: eine sechste Ausführung eines erfindungsgemäßen elektronischen Bauteils mit einem äußeren Reflektor im Längsschnitt,
- Fig. 9: eine erste Ausführung einer erfindungsgemäßen Messzelle,
- Fig. 10: eine zweite Ausführung einer erfindungsgemäßen Messzelle mit einer Spiegeleinheit und
- Fig. 11: eine dritte Ausführung einer erfindungsgemäßen Messzelle mit mehreren Spiegeleinheiten.

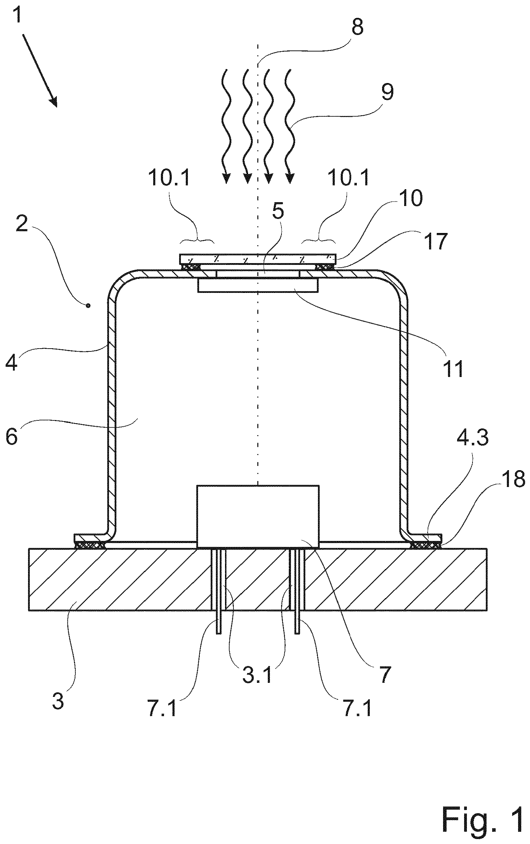

Ein erfindungsgemäßes elektronisches Bauteil 1 weist als wesentliche Elemente ein Gehäuse 2, das durch eine Gehäusekappe 4 mit einem Durchbruch 5 und einen Träger 3, über dem die Gehäusekappe 4 aufgesetzt ist, gebildet ist, sowie ein Fensterelement 10 und ein elektrooptisches oder optoelektronisches Wandlerelement 7 auf (Fig. 1).

Der Träger 3 ist als Platte aus Kovar ausgebildet und dient dem Gehäuse 2 als Basisplatte. Auf einer Oberfläche einer der Seitenflächen des Trägers 3 ist die Gehäusekappe 4 haubenartig aufgesetzt. Von den Innenseiten der Gehäusekappe 4 und Bereichen der Seitenfläche des Trägers 3 wird ein Innenraum 6 umschlossen, in dem das Wandlerelement 7 angeordnet ist. Das Wandlerelement 7 weist Kontaktelemente 7.1 zur elektrischen Kontaktierung des Wandlerelements 7 auf, die durch Kontaktöffnungen 3.1 des Trägers 3 geführt und mit Glas hermetisch gasdicht in den Kontaktöffnungen 3.1 eingeschmolzen sind.

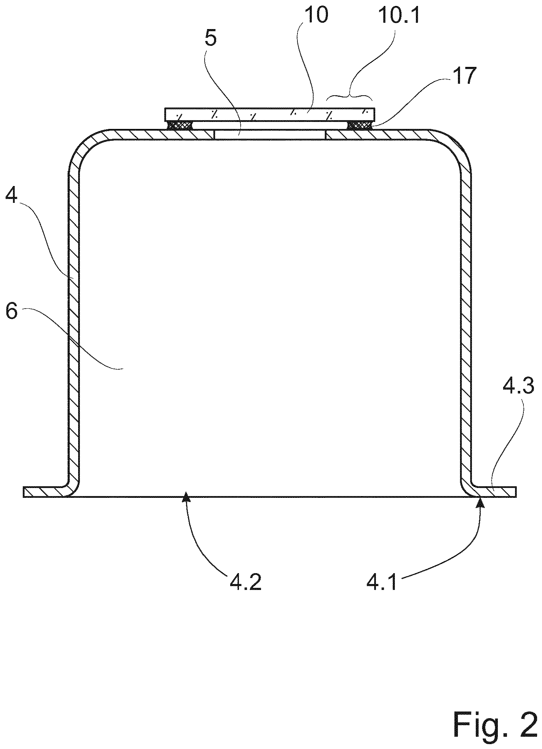

Die Gehäusekappe 4 besteht aus Nickel und weist in einer Fußfläche 4.1 eine Öffnung 4.2 auf (siehe auch Fig. 2). Die Wand der Gehäusekappe 4 ist um die Öffnung 4.2 herum nach außen gebogen und bildet so einen umlaufenden Rand 4.3, durch den die Öffnung 4.2 umgrenzt ist. In einem nach oben weisend gezeigten Bereich der Gehäusekappe 4 ist gegenüber dem Träger 3 in der Gehäusekappe 4 ein Durchbruch 5 vorhanden. Über dem Durchbruch 5 ist außerhalb des Innenraums 6 das Fensterelement 10 angeordnet, durch das der Durchbruch 5 vollständig überdeckt ist. Direkt unterhalb des Durchbruchs 5 ist im Innenraum 6 ein optisches Filter 11 gehaltert. Von dem Durchbruch 5 bis zu dem Wandlerelement 7 ist ein Strahlengang 8 für eine Strahlung 9 realisierbar, die für das Wandlerelement 7 relevant ist. Das optische Filter 11 ist in diesem Strahlengang 8 angeordnet. In den Fig. 1 bis 11 sind vereinfachend keine Halterungen der beschriebenen Elemente wie z. B. des optischen Filters 11 gezeigt.

Das Fensterelement 10 ist in seinen Abmaßen größer als der Durchbruch 5 und überragt mit einem Randbereich 10.1 den Durchbruch 5 allseitig (siehe auch Fig. 2). Auf derjenigen Seitenfläche des Fensterelements 10, die der Gehäusekappe 4 zugewandt ist (untere Seitenfläche), ist auf dem Randbereich 10.1 eine Randmetallisierung 10.2 vorhanden, die aus einer Schichtenfolge von mindestens zwei Schichten besteht, wobei beginnend am Fensterelement 10 eine erste Schicht aus Chrom oder Titan und eine zweite Schicht aus mindentens einem Element der Gruppe Nickel, Eisen-Nickel, Platin und Palladium als Randmetallisierung aufgetragen sind. Zwischen der Randmetallisierung 10.2 und dem Bereich der Gehäusekappe 4 rund um den Durchbruch 5 ist eine erste Naht 17 vorhanden, die durch erschmolzenes Lotmaterial gebildet ist. Durch die erste Naht 17 sind das Fensterelement 10 und die Gehäusekappe 4 hermetisch gasdicht miteinander verbunden.

Die Gehäusekappe 4 ist entlang des umlaufenden Rands 4.3 durch eine zweite Naht 18 hermetisch gasdicht mit dem Träger 3 verschweißt.

Eine erfindungsgemäße Gehäusekappe 4 ist in Fig. 2 gezeigt. Wie zu Fig. 1 beschrieben, umschließt die Gehäusekappe 4 an fünf Seiten den Innenraum 6. Die Fußfläche 4.1 weist die Öffnung 4.2 auf, welche durch den umlaufenden Rand 4.3 umgrenzt ist. Über dem Durchbruch 5 ist mittels der ersten Naht 17 das Fensterelement 10 aufgebracht und hermetisch gasdicht mit der Gehäusekappe 4 verbunden.

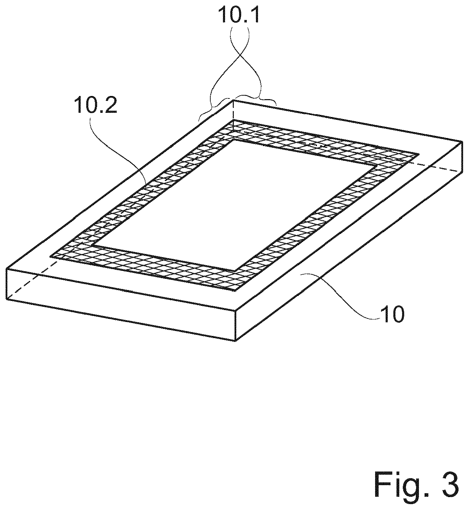

Eine perspektivische Ansicht auf die untere Seitenfläche eines erfindungsgemäßen Fensterelements 10 zeigt gemäß Fig. 3 den Randbereich 10.1 sowie die Randmetallisierung 10.2, die auf der Seitenfläche umlaufend ausgebildet ist. Die Randmetallisierung 10.2 besteht aus mindestens zwei übereinander auf einen umlaufenden Abschnitt des Randbereichs aufgedampften metallischen Schichten.

In weiteren Ausführungen der Erfindung kann die Randmetallisierung 10.2 auch mittels PVD aufgesputtert sein.

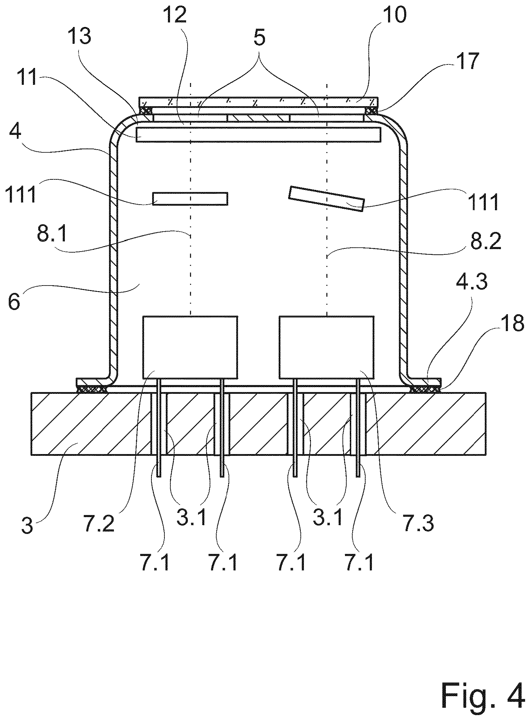

Eine zweite Ausführung des erfindungsgemäßen elektronischen Bauteils ist gemäß Fig. 4 mit einem ersten Wandlerelement 7.2 und einem zweiten Wandlerelement 7.3 ausgerüstet. In der Gehäusekappe 4 ist oberhalb des ersten Wandlerelements 7.2 und dem zweiten Wandlerelement 7.3 jeweils ein Durchbruch 5 vorhanden. Die beiden Durchbrüche 5 sind von einem gemeinsamen Fensterelement 10 überdeckt und hermetisch gasdicht verschlossen. Zwischen dem ersten Wandlerelement 7.2 und dem darüber vorhandenen Durchbruch 5 ist ein erster Strahlengang 8.1 und zwischen dem zweiten Wandlerelement 7.3 und dem darüber vorhandenen Durchbruch 5 ist ein zweiter Strahlengang 8.2 gegeben. In den beiden Strahlengängen 8.1, 8.2 ist ein optisches Filter 11 angeordnet das von den Durchbrüchen 5 beabstandet ist, so dass zwischen dem optischen Filter 11, den Durchbrüchen 5 und dem Fensterelement ein Zwischenraum 12 gebildet ist. Der Zwischenraum 12 steht durch einen Kanal 13 mit dem Innenraum 6 in Verbindung. Im weiteren Verlauf der beiden Strahlengänge 8.1, 8.2 ist jeweils ein weiteres optisches Filter 111 angeordnet, das ausschließlich dem ersten Strahlengang 8.1 bzw. ausschließlich dem zweiten Strahlengang 8.2 zugeordnet ist. Während das weitere optische Filter 111 in dem ersten Strahlengang 8.1 orthogonal zum ersten Strahlengang 8.1 ausgerichtet ist, ist das weitere optische Filter 111 in dem zweiten Strahlengang 8.2 gegenüber dem zweiten Strahlengang 8.2 verkippt. Der erste Strahlengang 8.1 ist ein Messstrahlengang, der zweite Strahlengang 8.2 ist ein Referenzstrahlengang.

In weiteren Ausführungen des erfindungsgemäßen elektronischen Bauteils können die weiteren Filter 111 auch beide gegenüber dem ersten Strahlengang 8.1 bzw. gegenüber dem zweiten Strahlengang 8.2 verkippt sein, um beispielsweise optische Parameter der beiden Strahlengänge 8.1, 8.2 zu justieren. Dazu sind die weiteren Filter 111 einstellbar gestaltet, d.h. deren Kippwinkel sind gezielt veränder- und einstellbar.

Jedes der Wandlerelemente 7.2 uns 7.3 weist Kontaktelemente 7.1 auf, die durch Kontaktöffnungen 3.1 des Trägers 3 geführt und dort hermetisch gasdicht mit Glas eingegossen sind. Die Gehäusekappe 4 ist mit dem Träger 3 durch die zweite Naht 18 verbunden. Die zweite Naht 18 ist in diesem Beispiel mittels eines Impulsschweißverfahrens erzeugt. Dabei wird kein Schweißzusatzwerkstoff eingesetzt, sondern das Material der Gehäusekappe 4 und des Trägers 3 wird im Bereich des umlaufenden Randes 4.3 und des Trägers 3 unterhalb des umlaufenden Randes 4.3 teilweise aufgeschmolzen.

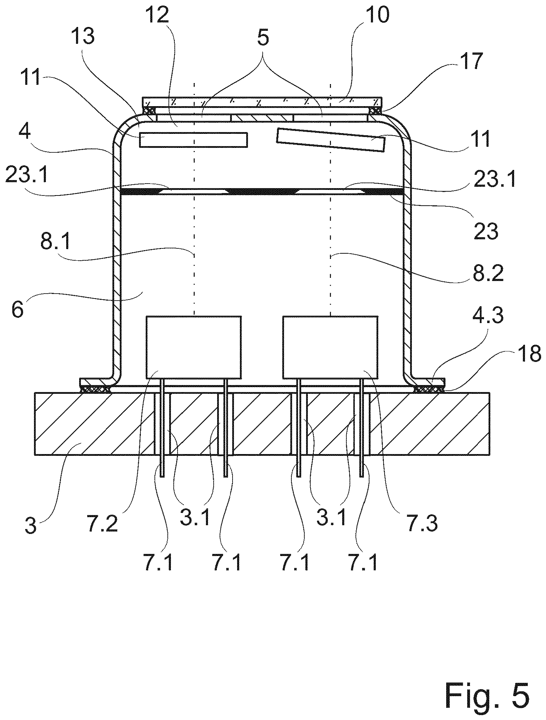

In einem dritten, in Fig. 5 gezeigten, Ausführungsbeispiel des erfindungsgemäßen elektronischen Bauteils 1 folgt der Aufbau grundsätzlich dem in Fig. 4 dargestellten, allerdings sind dem ersten Strahlengang 8.1 und dem zweiten Strahlengang 8.2 jeweils ein optisches Filter 11 zugeordnet. Weiterhin ist in den Strahlengängen 8.1 und 8.2 jeweils eine Blende 23 mit einer Blendenöffnung 23.1 vorhanden. Die Blenden 23 weisen Ränder auf, die bis an die Innenseite der Gehäusekappe 4 reichen und somit den Innenraum 6 horizontal unterteilen. Die Strahlung 9 kann nur durch die jeweilige Blendenöffnung 23.1 durchtreten. Dadurch wird vermieden, dass sich unerwünschte Streustrahlung entlang des ersten bzw. des zweiten Strahlengangs 8.1 bzw. 8.2 ausbreitet. Streustrahlung kann beispielsweise durch Strahlungsanteile verursacht sein, die aus den Stirnseiten der optischen Filter 11 und / oder der weiteren optischen Filter 111 austreten.

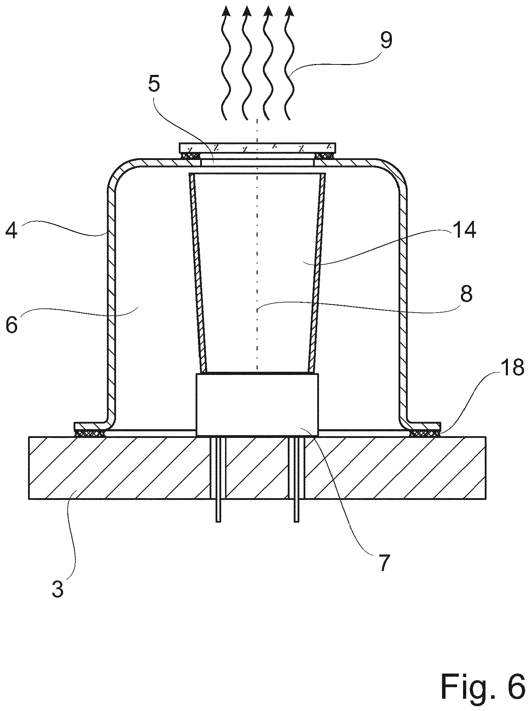

In einem vierten Ausführungsbeispiel des erfindungsgemäßen elektronischen Bauteils 1 ist ein Wandlerelement 7 in dem Innenraum 6 angeordnet (Fig. 6). Die Gehäusekappe 4 weist einen Durchbruch 5 auf. Das Wandlerelement 7 ist ein elektrooptisches Wandlerelement und ist zu Abstrahlung von Strahlung 9 in einem Wellenlängenbereich von Infrarotstrahlung zwischen 0,8 und 25 µm ausgelegt. Über dem Wandlerelement 7 ist im Innenraum 6 ein innerer Reflektor 14 so angeordnet, dass ein erster Abschnitt des Strahlengangs 8 von dem inneren Reflektor 14 rotationssymmetrisch umfangen ist. Der innere Reflektor 14 weist eine konische Form auf und ist auf seiner Innenseite mit einer Beschichtung versehen (nicht gezeigt), durch die IR-Strahlung reflektiert wird. Das Wandlerelement 7, der innerer Reflektor 14 und der Durchbruch 5 sind so zueinander ausgerichtet, dass eine von dem Wandlerelement 7 abgestrahlte Strahlung 9 durch den inneren Reflektor 14 gesammelt und als gerichtetes Strahlenbündel durch den Durchbruch 5 abgestrahlt wird. Der innere Reflektor 14 ist auf dem Wandlerelement 7 aufgelötet. In weiteren Ausführungen ist der innere Reflektor 14 durch eine Haltevorrichtung (nicht gezeigt) gehalten. Die zweite Naht 18 ist durch Löten gebildet.

Der innere Reflektor 14 kann in weiteren Ausführungen auch elliptische oder parabolische Formen aufweisen. Er kann außerdem auch eine Freiform, beispielsweise eine Zusammensetzung elliptischer und parabolische Abschnitte, aufweisen.

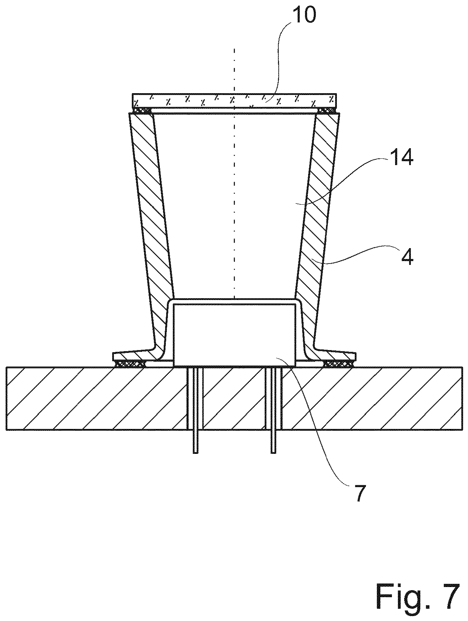

Eine alternative Ausführung des inneren Reflektors 14 besteht darin, dass eine Innenseite der Gehäusekappe 4 als ein innerer Reflektor 14 geformt und beschichtet ist, wie dies vereinfacht in Fig. 7 dargestellt ist.

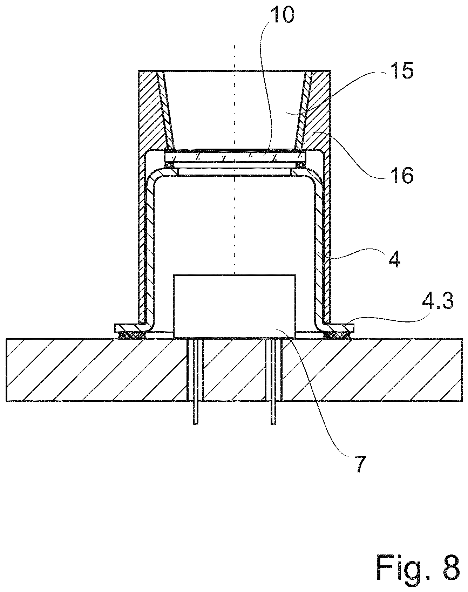

Bei einer sechsten Ausführung eines erfindungsgemäßen elektronischen Bauteils 1 ist ein äußerer Reflektor 15 auf der Gehäusekappe 4 und über dem Fensterelement 10 aufgesetzt (Fig. 8). Der äußere Reflektor 15 weist seitlich eine Reflektorhalterung 16 auf. Die Gehäusekappe 4 ist durch die Reflektorhalterung 16 an ihren Seiten umfasst. Um eine hohe Positionstreue des äußeren Reflektors 15 zu erreichen, steht die Reflektorhalterung 16 auf der Oberseite des umgebogene umlaufenden Rands 4.3 auf. Der äußere Reflektor 15 kann in weiteren Ausführungen mit der Gehäusekappe 4 flächig, bereichsweise oder punktuell stoffschlüssig verbunden, insbesondere geklebt, aufgelötet oder aufgeschweißt, sein.

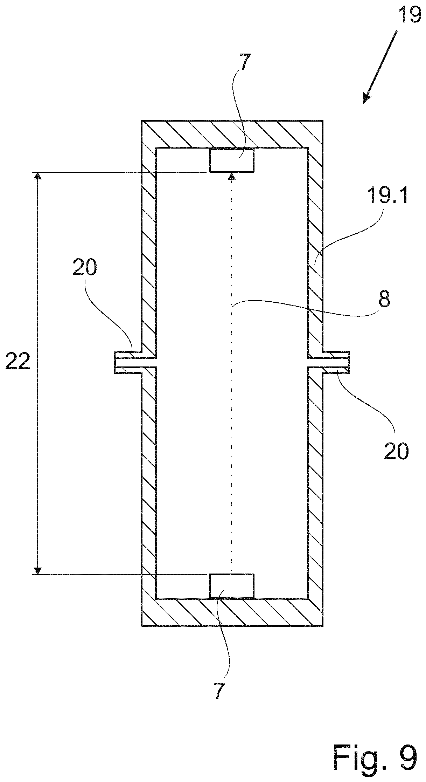

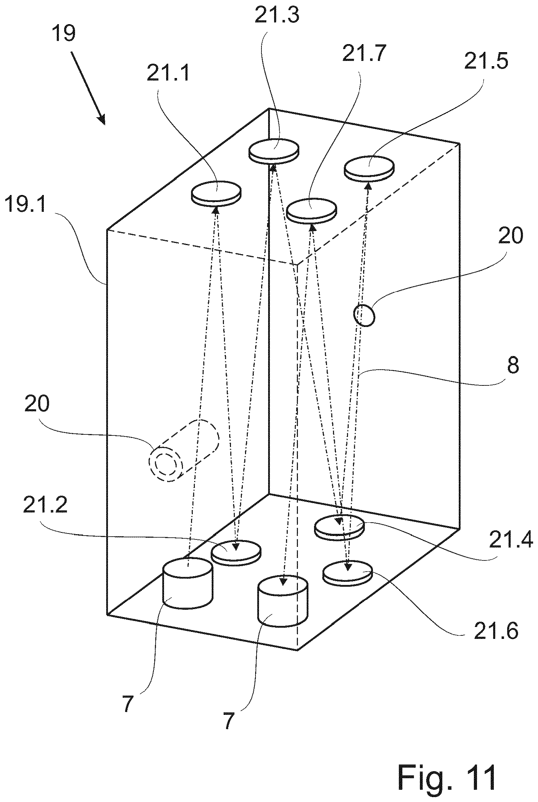

In der Fig. 9 ist ein erstes Ausführungsbeispiel einer Messzelle 19 unter Verwendung der erfindungsgemäßen optoelektronischen und elektrooptischen Wandlerelemente 7 schematisch gezeigt. Die Messzelle 19 weist ein rohrförmiges Messzellengehäuse 19.1 aus Aluminium auf, in dessen Seitenwänden zwei Durchtrittsöffnungen 20 zum Ein- bzw. zum Ausleiten eines zu messenden Mediums vorhanden sind. Das Messzellengehäuse 19.1 kann sowohl zylindrisch rohrförmig als auch in Form eines n-seitigen Prismas rohrförmig (nur in Fig. 11 gezeigt) ausgebildet sein. An einem stirnseitigen Ende des Messzellengehäuses 19.1 ist ein als Strahlereinheit fungierendes, elektrooptisches Wandlerelement 7 angeordnet. An dem anderen stirnseitigen Ende des Messzellengehäuses 19.1 ist ein weiteres, als Sensor fungierendes, optoelektronisches Wandlerelement 7 angeordnet. Beide Wandlerelemente 7 sind einander zugewandt und liegen sich gegenüber. Die Verlängerungen der Strahlengänge 8 der beiden Wandlerelemente 7 bilden eine gemeinsame optische Achse und sind als Strichlinie gezeigt. Durch den Abstand der Wandlerelemente 7 zueinander ist eine Messstrecke 22 gegeben.

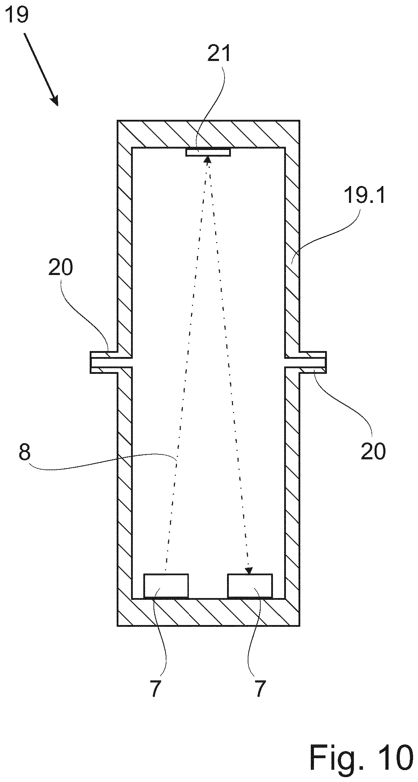

Eine zweite Ausführung einer erfindungsgemäßen Messzelle 19 ist in Fig. 10 gezeigt. An einem stirnseitigen Ende des Messzellengehäuses 19.1 sind nebeneinander zwei Wandlerelemente 7 angeordnet, von denen einer als Sensor und einer als Strahlereinheit ausgebildet ist. Beide Wandlerelemente 7 sind in Richtung des gegenüberliegenden Endes des Messzellengehäuses 19.1 gerichtet. An dem gegenüberliegenden Ende des Messzellengehäuses 19.1 ist eine Spiegeleinheit 21 so angeordnet, dass zwischen den beiden Wandlerelementen 7 eine gemeinsame, einmal gefaltete optische Achse gegeben ist. Durch diese Maßnahme ist, bei gleichbleibender Länge des Messzellengehäuses 19.1 die Messstrecke 22 (als Strichlinie symbolisiert) mehr als verdoppelt.

Um die Messstrecke 22 bei gleichbleibender Länge des Messzellengehäuses 19.1 noch weiter zu verlängern, können weitere Spiegeleinheiten 21 angeordnet sein, wie dies in Fig. 11 gezeigt ist. In diesem dritten Ausführungsbeispiel der Messzelle 19 sind wiederum nebeneinander zwei Wandlerelemente 7 angeordnet, von denen einer als Sensor und einer als Strahlereinheit ausgebildet ist. Am gegenüberliegenden Ende des Messzellengehäuses 19.1 sind nebeneinander vier Spiegeleinheiten 21, eine erste Spiegeleinheit 21.1, eine dritte Spiegeleinheit 21.3, eine fünfte Spiegeleinheit 21.5 und eine siebte Spiegeleinheit 21.7 angeordnet. Neben den beiden Wandlerelementen 7 sind eine zweite Spiegeleinheit 21.2, eine vierte Spiegeleinheit 21.4 und eine sechste Spiegeleinheit 21.6 vorhanden. Eine gemeinsame optische Achse der beiden Wandlerelemente 7 ist siebenfach gefaltet und verläuft von dem einen Wandlerelement 7 zur ersten Spiegeleinheit 21.1, von dort nacheinander weiter zur zweiten Spiegeleinheit 21.2 bis zur siebten Spiegeleinheit 21.7 und von dieser dann zu der anderen Wandlereinheit 7. Die Messstrecke 22 (Strichlinie) ist durch diese Anordnung mehr als achtmal so lang wie die Messstrecke 22 in dem ersten Ausführungsbeispiel gemäß Fig. 9.

### Bezugszeichen

- 1: elektronisches Bauteil
- 2: Gehäuse
- 3: Träger
- 3.1: Kontaktöffnung
- 4: Gehäusekappe
- 4.1: Fußfläche
- 4.2: Öffnung
- 4.3: umlaufender Rand
- 5: Durchbruch
- 6: Innenraum
- 7: Wandlerelement
- 7.1: Kontaktelemente
- 7.2: erstes Wandlerelement
- 7.3: zweites Wandlerelement
- 8: Strahlengang
- 8.1: erster Strahlengang
- 8.2: zweiter Strahlengang
- 9: Strahlung
- 10: Fensterelement
- 10.1: Randbereich
- 10.2: Randmetallisierung
- 11: optisches Filter
- 111: weiteres optisches Filter
- 12: Zwischenraum
- 13: Kanal
- 14: innerer Reflektor
- 15: äußerer Reflektor
- 16: Reflektorhalterung
- 17: erste Naht
- 18: zweite Naht
- 19: Messzelle
- 19.1: Messzellengehäuse
- 20: Durchtrittsöffnung
- 21: Spiegeleinheit
- 21.1: erste Spiegeleinheit
- 21.2: zweite Spiegeleinheit
- 21.3: dritte Spiegeleinheit
- 21.4: vierte Spiegeleinheit
- 21.5: fünfte Spiegeleinheit
- 21.6: sechste Spiegeleinheit
- 21.7: siebte Spiegeleinheit
- 22: Messstrecke
- 23: Blende
- 23.1: Blendenöffnung

## Patentansprüche

1. Verfahren zur Herstellung eines hermetisch gasdichten optoelektronischen oder elektrooptischen Bauteils zur optoelektronischen Messung und Analyse von Gasen oder Gasgemischen mit hoher Robustheit gegen Wärme und Feuchtigkeit, mit den folgenden Schritten:
a) Bereitstellen eines Trägers (3) für mindestens ein optoelektronisches oder elektrooptisches Wandlerelement (7), der zugleich als Basisplatte eines Gehäuses (2) verwendet wird,
b) Bereitstellen einer Gehäusekappe (4), die an einer Fußfläche (4.1) eine Öffnung (4.2) aufweist und die aus einem metallischen Material mit einer Leckrate kleiner als 10⁻⁸ mbar l/s besteht,
c) Erzeugen mindestens eines Durchbruchs (5) in der Gehäusekappe (4) so, dass nach einem Aufsetzen der Gehäusekappe (4) auf den Träger (3), in dessen Folge durch die Gehäusekappe (4) über dem Träger (3) ein Innenraum (6) zur Aufnahme des mindestens einen Wandlerelements (7) gebildet wird, für das mindestens eine Wandlerelement (7) relevante Strahlung (9) entlang eines im Wesentlichen orthogonal zum Träger (3) ausgerichteten Strahlengangs (8) zwischen einem Durchbruch (5) und dem Wandlerelement (7) ungehindert die Gehäusekappe (4) passieren kann,
d) Bereitstellen mindestens eines Fensterelements (10), das für die wandlerelementrelevante Strahlung (9) transparent ist, mit einer an den jeweiligen Durchbruch (5) der Gehäusekappe (4) angepassten Form und Größe
e) Erzeugen einer umlaufenden Randmetallisierung (10.2) am Fensterelement (10) als Kontaktfläche zu einem Randbereich des mindestens einen Durchbruchs (5) in Form einer Schichtenfolge aus mindestens zwei Schichten, wobei das Fensterelement (10) beginnend mit einer ersten Schicht aus Chrom oder Titan und einer zweiten Schicht aus mindestens einem Element der Gruppe Nickel, Eisen-Nickel, Platin und Palladium beschichtet wird,
f) Montieren von Träger (3), Wandlerelement (7), Gehäusekappe (4) und des mindestens einen Fensterelements (10), wobei eine hermetisch gasdichte Verbindung zwischen der Gehäusekappe (4) und dem mindestens einem Fensterelement (10) durch das Erschmelzen eines metallischen Materials zwischen der Randmetallisierung (10.2) des mindestens einem Fensterelements (10) und der Gehäusekappe (4) hergestellt wird und eine hermetisch gasdichte Verbindung zwischen der Gehäusekappe (4) und dem Träger (3) durch Bilden einer zweiten Naht (18) von erschmolzenem metallischen Material hermetisch gasdicht mit dem Träger (3) hergestellt wird und die Gehäusekappe (4) vor dem Verbinden mit dem Träger (3) so auf dem Träger (3) positioniert wird, dass der mindestens eine Durchbruch (5) gegenüber dem jeweils erforderlichen Strahlengang (8) des mindestens einen Wandlerelements (7) ausgerichtet ist.

2. Verfahren nach Anspruch 1, **dadurch gekennzeichnet, dass** das Fensterelement (10) als eine Platte aus einem transparenten Material der Gruppe Saphir (Al₂O₃), Magnesiumfluorid (MgF₂), Magnesiumoxid (MgO), Lithiumfluorid (LiF), Calciumfluorid (CaF₂), Bariumfluorid (BaF₂), Silizium (Si), Siliziumdioxid (SiO₂) Germanium (Ge), Zinkselenid (ZnSe), Zinksulfid (ZnS), Cadmiumtellurid (CdTe), Galliumarsenid (GaAs), Titandioxid (TiO₂), Y-teilstabilisiertes Zirkoniumdioxid (ZrO₂), einer Mischung aus Thalliumbromid und Thalliumjodid (KRS 5; TI(Br-J)) Flintglas oder Quarzglashergestellt wird.

3. Verfahren nach Anspruch 1 oder 2, **dadurch gekennzeichnet, dass** die Randmetallisierung (10.2) weiterhin eine dritte Schicht enthält, wobei die Schichtenfolge aus den mindestens zwei Schichten ergänzt ist mit der dritten Schicht aus Gold oder Nickel als Schutzschicht oder Benetzungsschicht.

4. Verfahren nach einem der Ansprüche 1 bis 3, **dadurch gekennzeichnet, dass** die Randmetallisierung (10.2) mittels eines Gasphasenabscheidungsverfahrens oder mittels eines elektrochemischen Verfahrens erfolgt.

5. Verfahren nach Anspruch 4, **dadurch gekennzeichnet, dass** vor der Herstellung der hermetisch gasdichten Verbindung zwischen der Gehäusekappe (4) und dem Träger (3) der Innenraum (6) entweder mit einem Gas oder mit einem Gasgemisch gefüllt oder evakuiert wird.

6. Elektronisches Bauteil (1) zur optoelektronischen Messung und Analyse von Gasen oder Gasgemischen mit einem Gehäuse (2), aufweisend eine Gehäusekappe (4), einen Träger (3) als Basisplatte des Gehäuses (2) und einen Innenraum (6), der von der Gehäusekappe (4) und dem Träger (3) umschlossen ist, sowie mit mindestens einem in dem Innenraum (6) angeordneten optoelektronischen oder elektrooptischen Wandlerelement (7), das durch den Träger (3) hindurchgeführte, hermetisch dicht in den Träger (3) eingebrachte, elektrische Kontakte aufweist, wobei die Gehäusekappe (4), die aus einem metallischen Material mit einer Leckrate kleiner als 10⁻⁸ mbar l/s besteht, mit dem Träger (3) durch eine stoffschlüssige Verbindung aus erschmolzenem Metall hermetisch gasdicht verschlossen ist, wobei
- in der Gehäusekappe (4) mindestens ein Durchbruch (5) zum Passieren von für das mindestens eine Wandlerelement (7) relevanter Strahlung (9) vorhanden ist und
- der mindestens eine Durchbruch (5) mit mindestens einem Fensterelement (10) durch eine stoffschlüssige metallische Verbindung mittels einer Randmetallisierung des Fensterelements (10) hermetisch gasdicht verschlossen ist,
**dadurch gekennzeichnet, dass**
- das Fensterelement (10) durch eine umlaufende erste Naht (17) eines erschmolzenen metallischen Materials entlang der umlaufenden Randmetallisierung (10.2) um den mindestens einen Durchbruch (5) mit der Gehäusekappe (4) hermetisch gasdicht verbunden ist, wobei
- das Fensterelement (10) mindestens für die für das mindestens eine Wandlerelement (7) relevante Strahlung (9) transparent ist, sodass die relevante Strahlung (9) entlang eines im Wesentlichen orthogonal zwischen dem Durchbruch (5) und dem Wandlerelement (7) ausgerichteten Strahlengangs (8) passieren kann, und
- die Randmetallisierung (10.2) des Fensterelements (10) zum Verbinden mit der Gehäusekappe (4) aus einer Schichtenfolge von mindestens zwei Schichten besteht, wobei beginnend am Fensterelement (10) eine erste Schicht aus Chrom oder Titan und eine zweite Schicht aus mindestens einem Element der Gruppe Nickel, Eisen-Nickel, Platin und Palladium als Randmetallisierung aufgetragen sind.

7. Elektronisches Bauteil (1) nach Anspruch 6, **dadurch gekennzeichnet, dass** mindestens einem der Durchbrüche (5) im jeweiligen Strahlengang (8) mindestens ein optisches Filter (11, 111) zugeordnet ist.

8. Elektronisches Bauteil (1) nach Anspruch 6 oder 7, **dadurch gekennzeichnet, dass** mindestens zwei hermetisch gasdicht mit mindestens einem Fensterelement (10) verbundene Durchbrüche (5) für separate Strahlengänge (8, 8.1, 8.2) zu je einem optoelektronischen Empfänger vorhanden sind.

9. Elektronisches Bauteil (1) nach Anspruch 8, **dadurch gekennzeichnet, dass** die separaten Strahlengänge (8, 8.1, 8.2) zu je einem Empfänger mindestens ein Messstrahlengang und mindestens ein Referenzstrahlengang sind.

10. Elektronisches Bauteil (1) nach einem der Ansprüche 7 bis 9, **dadurch gekennzeichnet, dass** zwischen dem optischen Filter (11) und dem Fensterelement (10) ein Zwischenraum (12) vorhanden ist.

11. Elektronisches Bauteil (1) nach Anspruch 10, **dadurch gekennzeichnet, dass** der Innenraum (6) des Gehäuses (2) und der Zwischenraum (12) zwischen dem optischen Filter (11) und dem Fensterelement (10) durch mindestens einen Kanal (13) zum Gasaustausch und Druckausgleich verbunden ist.

12. Elektronisches Bauteil (1) nach Anspruch 6, **dadurch gekennzeichnet, dass** das Wandlerelement (7) eine elektrooptische Strahlungsquelle ist und rotationssymmetrisch entlang eines anfänglichen Abschnitts des Strahlengangs (8) ein innerer Reflektor (14) angeordnet ist, sodass das elektronische Bauteil (1) als eine Strahlereinheit zur Abstrahlung eines gerichteten Bündels der Strahlung (9) für die optoelektronische Messung und Analyse von Gasen oder Gasgemischen durch den optoelektronischen Empfänger ausgebildet ist.

13. Elektronisches Bauteil (1) nach Anspruch 6, **dadurch gekennzeichnet, dass** das Wandlerelement (7) eine elektrooptische Strahlungsquelle ist und auf der Gehäusekappe (4) über dem Durchbruch (5) ein äußerer Reflektor (15) vorhanden ist, sodass das elektronische Bauteil (1) mit dem äußeren Reflektor (15) als eine Strahlereinheit zur Abstrahlung eines gerichteten Bündels der Strahlung (9) für die optoelektronische Messung und Analyse von Gasen oder Gasgemischen ausgebildet ist.

14. Messzelle (19) mit mindestens einem elektronischen Bauteil (1) nach einem der Ansprüche 6 bis 12 und mit mindestens einem elektronischen Bauteil (1) nach einem der Ansprüche 13 und 14, **dadurch gekennzeichnet, dass** beide elektronischen Bauteile (1) einander gegenüberliegend entlang einer gemeinsamen optischen Achse positioniert und mittels eines Messzellengehäuses (19.1) in einem definierten Abstand, der eine Messstrecke (22) bildet, gehaltert sind.

15. Messzelle (19) mit mindestens einem elektronischen Bauteil (1) nach einem der Ansprüche 6 bis 12 und mit mindestens einem elektronischen Bauteil (1) nach einem der Ansprüche 13 und 14, **dadurch gekennzeichnet, dass** beide elektronischen Bauteile (1) nebeneinander angeordnet sind und entlang einer gemeinsamen, mindestens einmal umgelenkten, optischen Achse positioniert sind, wobei zum Umlenken der optischen Achse mindestens eine Spiegeleinheit (21) gegenüber den beiden elektronischen Bauteilen (1) mittels eines Messzellengehäuses (19.1) gehaltert ist.

16. Messzelle nach einem der Ansprüche 14 oder 15, **dadurch gekennzeichnet, dass** das Messzellengehäuse (19.1) als ein rohrförmiges Gebilde mit Durchtrittsöffnungen (20) zum Gasdurchtritt ausgebildet ist.

## Claims

1. A method for producing a hermetically gas-tight optoelectronic or electro-optical component for optoelectronic measurement and analysis of gases or gas mixtures with high robustness against heat and moisture, comprising the following steps:
a) providing a carrier (3) for at least one optoelectronic or electro-optical transducer element (7), said carrier (3) also being used as the base plate of a housing (2),
b) providing a housing cap (4) which has an opening (4.2) on a base surface (4.1) and which consists of a metallic material with a cover rate of less than 10⁻⁸ mbar l/s,
c) creating at least one breakthrough (5) in the housing cap (4) such that, after the housing cap (4) has been placed on the carrier (3), an interior space (6) for receiving the at least one transducer element (7) is formed by the housing cap (4) above the carrier (3), radiation (9) relevant for the at least one transducer element (7) can pass unhindered through the housing cap (4) along a beam path (8) aligned substantially orthogonally to the carrier (3) between a breakthrough (5) and the transducer element (7),
d) providing at least one window element (10), which is transparent to the transducerrelevant radiation (9), with a shape and size adapted to the respective breakthrough (5) of the housing cap (4),
e) producing a circumferential edge metallisation (10.2) on the window element (10) as a contact surface to an edge region of the at least one breakthrough (5) in the form of a layer sequence of at least two layers, wherein the window element (10) is coated starting with a first layer of chromium or titanium and a second layer of at least one element from the group consisting of nickel, iron-nickel, platinum and palladium,
f) mounting carrier (3), transducer element (7), housing cap (4) and the at least one window element (10), wherein a hermetically gas-tight connection between the housing cap (4) and the at least one window element (10) is produced by melting a metallic material between the edge metallisation (10.2) of the at least one window element (10) and the housing cap (4) and a hermetically gas-tight connection between the housing cap (4) and the carrier (3) is produced by forming a second seam (18) of molten metallic material in a hermetically gas-tight manner with the carrier (3), and the housing cap (4) is positioned on the carrier (3) before being connected to the carrier (3), such that the at least one breakthrough (5) is aligned with respect to the respectively required beam path (8) of the at least one transducer element (7).

2. The method according to claim 1, **characterised in that** the window element (10) is manufactured as a plate made of a transparent material of the group sapphire (Al₂O₃), magnesium fluoride (MgF₂), magnesium oxide (MgO), lithium fluoride (LiF), calcium fluoride (CaF₂), barium fluoride (BaF₂), silicon (Si), silicon dioxide (SiO₂), germanium (Ge), zinc selenide (ZnSe), zinc sulphide (ZnS), cadmium telluride (CdTe), gallium arsenide (GaAs), titanium dioxide (TiO₂), partially Y-stabilised zirconium dioxide (ZrO₂), a mixture of thallium bromide and thallium iodide (KRS 5; TI(Br-J)), flint glass or quartz glass.

3. The method according to claim 1 or 2, **characterised in that** the edge metallisation (10.2) further contains a third layer, the layer sequence of the at least two layers being supplemented with the third layer of gold or nickel as a protective layer or wetting layer.

4. The method according to any one of claims 1 to 3, **characterised in that** the edge metallisation (10.2) is carried out by means of a vapour phase deposition process or by means of an electrochemical process.

5. The method according to claim 4, **characterised in that** before the hermetically gas-tight connection between the housing cap (4) and the carrier (3) is produced, the interior space (6) is filled or evacuated either with a gas or with a gas mixture.

6. An electronic component (1) for optoelectronic measurement and analysis of gases or gas mixtures with a housing (2), having a housing cap (4), a carrier (3) as the base plate of the housing (2) and an interior space (6) which is enclosed by the housing cap (4) and the carrier (3), and with at least one optoelectronic or electro-optical transducer element (7) arranged in the interior space (6), said transducer element (7) having electrical contacts which are guided through the carrier (3) and are hermetically sealed in the carrier (3), wherein the housing cap (4), which consists of a metallic material with a cover rate of less than 10⁻⁸ mbar l/s, is hermetically sealed in a gas-tight manner with the carrier (3) by a cohesive bond of molten metal, wherein
- at least one breakthrough (5) is provided in the housing cap (4) for the passage of radiation (9) relevant for the at least one transducer element (7), and
- the at least one breakthrough (5) is hermetically sealed in a gas-tight manner with at least one window element (10) by means of a material-locking metallic connection by means of edge metallisation of the window element (10),
**characterised in that**
- the window element (10) is connected to the housing cap (4) in a hermetically gas-tight manner by a circumferential first seam (17) of a molten metallic material along the circumferential edge metallisation (10.2) around the at least one breakthrough (5), wherein
- the window element (10) is transparent at least for the radiation (9) relevant for the at least one transducer element (7), so that the relevant radiation (9) can pass along a beam path (8) aligned substantially orthogonally between the breakthrough (5) and the transducer element (7), and
- the edge metallisation (10.2) of the window element (10) for connection to the housing cap (4) consists of a layer sequence of at least two layers, wherein a first layer of chromium or titanium and a second layer of at least one element from the group consisting of nickel, iron-nickel, platinum and palladium are applied as edge metallisation starting at the window element (10).

7. The electronic component (1) according to claim 6, **characterised in that** at least one optical filter (11, 111) is assigned to at least one of the breakthroughs (5) in the respective beam path (8).

8. The electronic component (1) according to claim 6 or 7, **characterised in that** at least two breakthroughs (5) for separate beam paths (8, 8.1, 8.2) to one optoelectronic receiver each are provided, which are connected in a hermetically gas-tight manner to at least one window element (10).

9. The electronic component (1) according to claim 8, **characterised in that** the separate beam paths (8, 8.1, 8.2) to one receiver each are at least one measuring beam path and at least one reference beam path.

10. The electronic component (1) according to any one of claims 7 to 9, **characterised in that** there is an intermediate space (12) between the optical filter (11) and the window element (10).

11. The electronic component (1) according to claim 10, **characterised in that** the interior space (6) of the housing (2) and the intermediate space (12) between the optical filter (11) and the window element (10) are connected by at least one channel (13) for gas exchange and pressure equalisation.

12. The electronic component (1) according to claim 6, **characterised in that** the transducer element (7) is an electro-optical radiation source and an inner reflector (14) is arranged rotationally symmetrically along an initial section of the beam path (8), so that the electronic component (1) is configured as a radiator unit for radiating a directed beam of the radiation (9) for the optoelectronic measurement and analysis of gases or gas mixtures by the optoelectronic receiver.

13. The electronic component (1) according to claim 6, **characterised in that** the transducer element (7) is an electro-optical radiation source and an external reflector (15) is present on the housing cap (4) above the breakthrough (5), so that the electronic component (1) with the external reflector (15) is configured as a radiator unit for radiating a directed beam of radiation (9) for the opto-electronic measurement and analysis of gases or gas mixtures.

14. A measuring cell (19) with at least one electronic component (1) according to any one of claims 6 to 12 and with at least one electronic component (1) according to any one of claims 13 and 14, **characterised in that** both electronic components (1) are positioned opposite one another along a common optical axis and are held by means of a measuring cell housing (19.1) at a defined distance, which forms a measuring path (22).

15. A measuring cell (19) with at least one electronic component (1) according to any one of claims 6 to 12 and with at least one electronic component (1) according to any one of claims 13 and 14, **characterised in that** both electronic components (1) are arranged next to one another and are positioned along a common optical axis which is deflected at least once, at least one mirror unit (21) being mounted opposite the two electronic components (1) by means of a measuring cell housing (19.1) in order to deflect the optical axis.

16. The measuring cell according to any one of claims 14 or 15, **characterised in that** the measuring cell housing (19.1) is configured as a tubular structure with throughopenings (20) for the passage of gas.

## Revendications

1. Procédé de fabrication d'un composant optoélectronique ou électro-optique hermétiquement étanche aux gaz pour la mesure et l'analyse optoélectroniques de gaz ou de mélanges de gaz avec une grande robustesse à la chaleur et à l'humidité, comprenant les étapes de :
a) fournir un support (3) pour au moins un élément transducteur optoélectronique ou électro-optique (7), qui est utilisé en même temps comme plaque de base d'un boîtier (2),
b) fournir un capuchon de boîtier (4) qui présente une ouverture (4.2) sur une surface de pied (4.1) et qui est constitué d'un matériau métallique ayant un taux de recouvrement inférieur à 10⁻⁸ mbar l/s,
c) créer au moins un trou (5) dans le capuchon de boîtier (4) de telle sorte qu'après une mise en place du capuchon de boîtier (4) sur le support (3), le capuchon de boîtier (4) formant ainsi un espace intérieur (6) au-dessus du support (3) destiné à recevoir l'au moins un élément transducteur (7), le rayonnement (9) pertinent pour l'au moins un élément transducteur (7) peut traverser librement le capuchon de boîtier (4) le long d'un trajet de faisceau (8) orienté sensiblement orthogonalement au support (3) entre un trou (5) et l'élément transducteur (7),
d) fournir au moins un élément de fenêtre (10), qui est transparent pour le rayonnement (9) pertinent pour l'élément transducteur et présente une forme et une taille adaptées au trou (5) respectif du capuchon de boîtier (4),
e) produire une métallisation de bord (10.2) périphérique sur l'élément de fenêtre (10) comme surface de contact avec une zone de bord de l'au moins une trou (5) sous la forme d'une succession de couches composée d'au moins deux couches, l'élément de fenêtre (10) étant revêtu en commençant par une première couche de chrome ou de titane et une deuxième couche d'au moins un élément du groupe nickel, fer-nickel, platine et palladium,
f) monter le support (3), l'élément transducteur (7), le capuchon de boîtier (4) et l'au moins un élément de fenêtre (10), une liaison hermétiquement étanche aux gaz entre le capuchon de boîtier (4) et l'au moins un élément de fenêtre (10) étant réalisée par fusion d'un matériau métallique entre la métallisation de bord (10.2) de l'au moins un élément de fenêtre (10) et le capuchon de boîtier (4), et une liaison hermétiquement étanche aux gaz entre le capuchon de boîtier (4) et le support (3) étant réalisée en formant un deuxième joint (18) de matériau métallique fondu de manière hermétiquement étanche aux gaz avec le support (3), et le capuchon de boîtier (4) étant positionné de cette manière sur le support (3) avant la liaison avec le support (3), de telle sorte que l'au moins un trou (5) soit orienté par rapport au trajet de faisceau (8) respectivement nécessaire de l'au moins un élément transducteur (7).

2. Procédé selon la revendication 1, **caractérisé en ce que** l'élément de fenêtre (10) est réalisé sous la forme d'une plaque en un matériau transparent du groupe saphir (Al₂O₃), fluorure de magnésium (MgF₂), oxyde de magnésium (MgO), fluorure de lithium (LiF), fluorure de calcium (CaF₂), fluorure de baryum (BaF₂), silicium (Si), dioxyde de silicium (SiO₂), germanium (Ge), séléniure de zinc (ZnSe), sulfure de zinc (ZnS), tellurure de cadmium (CdTe), arséniure de gallium (GaAs), dioxyde de titane (TiO₂), dioxyde de zirconium partiellement stabilisé par Y (ZrO₂), un mélange de bromure de thallium et d'iodure de thallium (KRS 5 ; TI(Br-J)), du verre flint ou du verre de quartz.

3. Procédé selon la revendication 1 ou 2, **caractérisé en ce que** la métallisation de bord (10.2) contient en outre une troisième couche, la séquence de couches constituée des au moins deux couches étant complétée par la troisième couche d'or ou de nickel en tant que couche de protection ou couche de mouillage.

4. Procédé selon l'une quelconque des revendications 1 à 3, **caractérisé en ce que** la métallisation de bord (10.2) est réalisée au moyen d'un procédé de dépôt en phase gazeuse ou au moyen d'un procédé électrochimique.

5. Procédé selon la revendication 4, **caractérisé en ce que**, avant la réalisation de la liaison hermétiquement étanche aux gaz entre le capuchon de boîtier (4) et le support (3), l'espace intérieur (6) est rempli ou mis sous vide soit avec un gaz, soit avec un mélange de gaz.

6. Composant électronique (1) pour la mesure et l'analyse optoélectroniques de gaz ou de mélanges de gaz avec un boîtier (2), présentant un capuchon de boîtier (4), un support (3) comme plaque de base du boîtier (2) et un espace intérieur (6), qui est entouré par le capuchon de boîtier (4) et le support (3), ainsi qu'avec au moins un élément transducteur optoélectronique ou électro-optique (7) disposé dans l'espace intérieur (6), qui présente des contacts électriques traversant le support (3) et introduits de manière hermétiquement étanche dans le support (3), le capuchon de boîtier (4), qui est constitué d'un matériau métallique ayant un taux de couverture inférieur à 10⁻⁸ mbar l/s, étant fermé de manière hermétiquement étanche aux gaz avec le support (3) par une liaison par matière en métal fondu, où
- il existe dans le capuchon de boîtier (4) au moins un trou (5) pour le passage du rayonnement (9) pertinent pour l'au moins un élément transducteur (7), et
- l'au moins un trou (5) est fermé de manière hermétiquement étanche aux gaz avec au moins un élément de fenêtre (10) par une liaison métallique par liaison de matière au moyen d'une métallisation de bord de l'élément de fenêtre (10),
**caractérisé en ce que**
- l'élément de fenêtre (10) est relié au capuchon de boîtier (4) de manière hermétiquement étanche aux gaz par une première soudure (17) périphérique d'un matériau métallique fondu le long de la métallisation de bord (10.2) périphérique autour de l'au moins un trou (5), où
- l'élément de fenêtre (10) est transparent au moins pour le rayonnement (9) pertinent pour l'au moins un élément de transducteur (7), de sorte que le rayonnement pertinent (9) peut passer le long d'un trajet de faisceau (8) orienté sensiblement orthogonalement entre le trou (5) et l'élément de transducteur (7), et
- la métallisation de bord (10.2) de l'élément de fenêtre (10) pour la liaison avec le capuchon de boîtier (4) est constituée d'une succession de couches d'au moins deux couches, une première couche de chrome ou de titane et une deuxième couche d'au moins un élément du groupe nickel, fer-nickel, platine et palladium étant appliquées comme métallisation de bord en commençant sur l'élément de fenêtre (10).

7. Composant électronique (1) selon la revendication 6, **caractérisé en ce qu'**au moins un filtre optique (11, 111) est associé à au moins l'un des trous (5) dans le trajet de faisceau (8) respectif.

8. Composant électronique (1) selon la revendication 6 ou 7, **caractérisé en ce qu'**il existe au moins deux trous (5) reliés de manière hermétiquement étanche aux gaz à au moins un élément de fenêtre (10) pour des trajets de faisceau (8, 8.1, 8.2) séparés vers un récepteur optoélectronique respectif.

9. Composant électronique (1) selon la revendication 8, **caractérisé en ce que** les trajets de faisceau séparés (8, 8.1, 8.2) vers un récepteur respectif sont au moins un trajet de faisceau de mesure et au moins un trajet de faisceau de référence.

10. Composant électronique (1) selon l'une quelconque des revendications 7 à 9, **caractérisé en ce qu'**un espace intermédiaire (12) est présent entre le filtre optique (11) et l'élément de fenêtre (10).

11. Composant électronique (1) selon la revendication 10, **caractérisé en ce que** l'espace intérieur (6) du boîtier (2) et l'espace intermédiaire (12) entre le filtre optique (11) et l'élément de fenêtre (10) sont reliés par au moins un canal (13) pour l'échange de gaz et l'équilibrage de pression.

12. Composant électronique (1) selon la revendication 6, **caractérisé en ce que** l'élément transducteur (7) est une source de rayonnement électro-optique, et un réflecteur interne (14) est disposé à symétrie de révolution le long d'une section initiale du trajet de faisceau (8), de sorte que le composant électronique (1) est conçu comme une unité de rayonnement pour émettre un faisceau dirigé du rayonnement (9) pour la mesure et l'analyse optoélectroniques de gaz ou de mélanges de gaz par le récepteur optoélectronique.

13. Composant électronique (1) selon la revendication 6, **caractérisé en ce que** l'élément convertisseur (7) est une source de rayonnement électro-optique et qu'un réflecteur extérieur (15) est présent sur le capuchon de boîtier (4) au-dessus du trou (5), de sorte que le composant électronique (1) avec le réflecteur extérieur (15) est conçu comme une unité de rayonnement pour l'émission d'un faisceau dirigé du rayonnement (9) pour la mesure et l'analyse optoélectroniques de gaz ou de mélanges de gaz.

14. Cellule de mesure (19) avec au moins un composant électronique (1) selon l'une quelconque des revendications 6 à 12 et avec au moins un composant électronique (1) selon l'une quelconque des revendications 13 et 14, **caractérisée en ce que** les deux composants électroniques (1) sont positionnés l'un en face de l'autre le long d'un axe optique commun et sont maintenus au moyen d'un boîtier de cellule de mesure (19.1) à une distance définie, qui forme une section de mesure (22).

15. Cellule de mesure (19) avec au moins un composant électronique (1) selon l'une quelconque des revendications 6 à 12 et avec au moins un composant électronique (1) selon l'une quelconque des revendications 13 et 14, **caractérisée en ce que** les deux composants électroniques (1) sont disposés l'un à côté de l'autre et sont positionnés le long d'un axe optique commun, dévié au moins une fois, au moins une unité de miroir (21) étant maintenue par rapport aux deux composants électroniques (1) au moyen d'un boîtier de cellule de mesure (19.1) pour dévier l'axe optique.

16. Cellule de mesure selon l'une quelconque des revendications 14 ou 15, **caractérisée en ce que** le boîtier de la cellule de mesure (19.1) est réalisé sous forme d'une structure tubulaire avec des ouvertures de passage (20) pour le passage de gaz.
